# EUROPÄISCHE PATENTSCHRIFT

(11) **EP 0 527 166 B1**
(45) Veröffentlichungstag und Bekanntmachung des Hinweises auf die Patenterteilung: **14.06.1995**
(21) Anmeldenummer: 91908272.7
(22) Anmeldetag: 02.05.1991
(51) Int. Cl.: G03F 7/20

(54) **BELICHTUNGSVORRICHTUNG**
ILLUMINATION DEVICE
DISPOSITIF D'EXPOSITION A LA LUMIERE

(30) Priorität: 02.05.1990 DE 4014131
(43) Veröffentlichungstag der Anmeldung: 17.02.1993
(73) Patentinhaber: FRAUNHOFER-GESELLSCHAFT ZUR FÖRDERUNG DER ANGEWANDTEN FORSCHUNG E.V., 80636 München (DE)
(72) Erfinder: VOGT, Holger, D-4330 Mülheim 13 (DE); KÜCK, Heinz, D-4100 Duisburg 28 (DE); HESS, Gunther, D-4100 Duisburg 1 (DE); GEHNER, Andreas, D-4100 Duisburg 1 (DE)
(74) Vertreter: Schoppe, Fritz, Dipl.-Ing.
(86) Internationale Anmeldenummer: DE9100375
(87) Internationale Veröffentlichungsnummer: WO9117483

(56) Entgegenhaltungen:
- EP-A- 0 358 467
- US-A- 4 675 702
- US-A- 4 728 185
- Proceedings of SPIE, Band 1018, 1988, (Bellingham, WA, US), W. Brinker et al.:"Deformation behavior of thin viscoelastic layers used in an active-matrix-addressed spatial light modulator", Seiten 79-85

## Beschreibung

Die vorliegende Erfindung betrifft eine Belichtungsvorrichtung zum Herstellen von Vorlagen, wie beispielsweise Retikels und Masken, für die Fertigung elektronischer Elemente oder zum Direktbelichten von Scheiben und Substraten bei den für die Herstellung notwendigen fotolithographischen Schritten oder von Strukturen mit lichtempfindlichen Schichten, wobei diese Belichtungsvorrichtung eine Lichtquelle und einen Mustergenerator umfaßt.

Insbesondere befaßt sich die vorliegende Erfindung mit der Herstellung von Vorlagen, Retikels und Masken oder mit der Direktbelichtung im Mikrometerbereich bei der Halbleiterfertigung, der Fertigung von integrierten Schaltkreisen, der Hybridfertigung und der Fertigung von flachen Bildschirmen sowie ähnlichen Fertigungsverfahren, bei denen Belichtungsprozesse eingesetzt werden. Insbesondere befaßt sich die Erfindung mit einer Belichtungsvorrichtung, wie sie für die Direktbelichtung von Halbleiterscheiben in der Halbleiterfertigung und von Substraten in der Hybrid- und Verbindungstechnik eingesetzt werden kann.

Bei der Herstellung von Retikels, die Belichtungsschablonen für die fotolithographische Schaltkreisherstellung sind, sowie bei der Herstellung von Masken und bei der Direktbelichtung von Halbleiterprodukten werden Elektronenstrahlschreiber, Laserstrahlgeräte und optische Mustergeneratoren mit einer Laserlichtquelle oder einer Quecksilberdampflampe eingesetzt. Optische Mustergeneratoren nach dem Stand der Technik erzeugen die gewünschten Strukturen durch das aufeinanderfolgende, einzelne Belichten von Rechteckfenstern, die durch mechanische Rechteckblenden festgelegt werden. Die Komplexität der zu erzeugenden Struktur bestimmt die Anzahl der erforderlichen Belichtungsrechtecke, die wiederum die Schreibzeit oder Belichtungszeit für die Struktur bestimmt. Die Genauigkeit der verwendeten mechanischen Rechteckblenden begrenzt wiederum die Genauigkeit der mit diesen bekannten Mustergeneratoren erzeugbaren Strukturen.

Bei Laserstrahlgeräten nach dem Stand der Technik wird die zu belichtende Fläche mit einem Laserstrahl abgerastert. Die Schreibgeschwindigkeit oder Belichtungsgeschwindigkeit derartiger Laserstrahlgeräte ist durch den für das Rasterverfahren notwendigen seriellen Datenfluß begrenzt. Ferner bedingen derartige Laserstrahlgeräte einen hohen mechanischoptischen Aufwand.

Die im Stand der Technik eingesetzten Elektronenstrahlgeräte können nur für die Belichtung von elektronenempfindlichen, speziellen Photolacksystemen verwendet werden und erfordern, verglichen mit den oben beschriebenen Laserstrahlgeräten, zusätzlich eine Hochvakuumtechnik. Elektronenstrahlgeräte erfordern daher sehr hohe Investitions- und Betriebskosten.

Aus der Fachveröffentlichung W. Brinker et al, "Deformation behavior of thin viscoelastic layers used in an active -matrix-addressed spatial light modulator", SPIE Electro-Optic and Magneto-Optic Materials (1988), Band 1018, Seiten 79-85 ist es bereits bekannt, für die Erzeugung von Fernsehbildern oder für Zwecke der Bildanzeige ein reflektives optisches Schlieren-System mit einem aktiven, Matrix-adressierten, viskoelastischen Flächenlichtmodulator einzusetzen. Dieser umfaßt eine Dauerlichtquelle, deren Licht durch ein geeignetes optisches System vertikal auf die Oberfläche des Flächenlichtmodulators auffällt. Oberflächenbereiche des Flächenlichtmodulators sind bei Adressierung von Steuerelektroden deformierbar, so daß das auf die Oberfläche fallende Licht bei adressierten Oberflächenelementen gebeugt, bei nicht-adressierten Oberflächenelementen ungebeugt reflektiert wird. Das ungebeugte Licht wird zur Lichtquelle zurückgelenkt, während das gebeugte Licht über das optische Schlierensystem zur Bilderzeugung auf dem Fernsehbildschirm oder auf einer Bildanzeigefläche verwendet wird.

Aus der Firmenschrift Texas Instruments, JMF 008:0260; 10/87 ist ein Flächenlichtmodulator bekannt, dessen reflektierende Oberfläche aus einer Vielzahl von elektrisch adressierbaren, mechanisch verformbaren Zungen besteht.

Die US-A-46 75 702 zeigt einen Photoplotter bzw. allgemein eine Belichtungsvorrichtung, die auch für die Direktbelichtung lichtempfindlicher Schichten bei der photolithographischen Herstellung integrierter Schaltungen dient. Bei diesem Photoplotter wird die von einem Rechner ansteuerbare Belichtung bestimmter Bereiche dadurch bewirkt, daß ein als Lichtventil ausgebildetes Gerät mit einzeln ansteuerbaren Ventilbereichen zwischen einer Quelle für paralleles Licht und der zu belichtenden, lichtempfindlichen Schicht angeordnet wird. Bezüglich des Lichtventiles ist beschrieben, daß dieses nach Art eines Negativs arbeiten soll und somit dazu dienen soll, adressierbare Bereiche durch elektronische Ansteuerung lichtundurchlässig zu schalten, so daß entsprechende Bereiche der lichtempfindlichen Schicht unbelichtet bleiben.

Gegenüber diesem Stand der Technik liegt der vorliegenden Erfindung die Aufgabe zugrunde, eine Belichtungsvorrichtung der eingangs genannten Art so weiterzubilden, daß bei einfacher und kostengünstiger Struktur der Belichtungsvorrichtung eine gegenüber Belichtungsvorrichtungen in Form von Laserstrahlanlagen oder Elektronenstrahlanlagen reduzierte Belichtungszeit oder Schreibzeit erzielt wird.

Diese Aufgabe wird bei einer Belichtungsvorrichtung nach dem Oberbegriff des Patentanspruchs 1 durch die im kennzeichnenden Teil des Patentanspruchs 1 angegebenen Merkmale gelöst.

Gemäß der Erfindung wird der Mustergenerator durch ein optisches Schlierensystem und einen aktiven, Matrix-adressierbaren Flächenlichtmodulator gebildet, wobei der Flächenlichtmodulator, der auch als zweidimensionaler Lichtmodulator bezeichnet werden kann, eine reflektierende Oberfläche aufweist, deren adressierte Oberflächenbereiche einfallendes Licht gebeugt und deren nicht-adressierte Oberflächenbereiche einfallendes Licht ungebeugt reflektieren. Das Schlierensystem hat ein flächenmodulatorseitiges Schlierenobjektiv und ein dem Flächenlichtmodulator abgewandtes Projektionsobjektiv und eine zwischen diesen Objektiven angeordnete Spiegelvorrichtung, die Licht von der Lichtquelle auf die Oberfläche des Flächenlichtmodulators richtet. Eine Fokussiereinrichtung fokussiert das von der Lichtquelle stammende Licht auf die Spiegelvorrichtung. Das Schlierenobjektiv ist mit einem bezogen auf seine Brennweite geringen Abstand zu dem Flächenlichtmodulator angeordnet. Eine Filtervorrichtung ist zwischen dem Schlierenobjektiv und dem Projektionsobjektiv angeordnet, die derart ausgebildet ist, daß sie das von den nicht-adressierten Oberflächenbereichen des Flächenlichtmodulators reflektierte, ungebeugte Licht herausfiltert und lediglich das von den adressierten Oberflächenbereichen reflektierte, gebeugte Licht über das Projektionsobjektiv zu der Vorlage oder dem elektronischen Element oder der Struktur durchläßt. Die Vorlage oder das elektronische Element oder die Struktur ist derart auf einem Positioniertisch festlegbar, daß die adressierten Oberflächenbereiche des Flächenlichtmodulators auf der Vorlage oder dem elektronischen Element oder der Struktur scharf abbildbar sind. Vorzugsweise ist die Spiegelvorrichtung um die Brennweite des Schlierenobjektivs von diesem beabstandet angeordnet, so daß sie eine Doppelfunktion erfüllen kann, nämlich einerseits das Licht von der Lichtquelle zu dem Flächenlichtmodulator umzulenken, und andererseits als Filtervorrichtung für reflektiertes Licht der nullten Beugungsordnung zu wirken, indem dieses ungebeugte Licht wiederum zu der Lichtquelle zurückgeworfen wird.

Gemäß einem wesentlichen Erfindungsaspekt handelt es sich bei der Lichtquelle der erfindungsgemäßen Belichtungsvorrichtung um eine gepulste Laserlichtquelle, deren Pulsdauer kürzer ist als die minimalen Abmessung der zu erzeugenden Struktur geteilt durch die Verfahrgeschwindigkeit des Positioniertisches. Bei dieser Ausgestaltung ermöglicht die erfindungsgemäße Belichtungsvorrichtung ein stroboskopartiges Belichten der Vorlage bzw. des elektronischen Elementes bzw. der Struktur während eines im wesentlichen kontinuierlichen Verfahrens des Positioniertisches, wodurch sehr hohe Schreibgeschwindigkeiten oder Belichtungsgeschwindigkeiten erzielt werden.

Trotz der hohen Belichtungsintensität der einzelnen Laserlichtpulse macht die Erfindung von einem Flächenlichtmodulator Gebrauch, wie er im Stand der Technik nur für Anwendungsfälle von sehr niedriger Belichtungsintensität herangezogen wird, wie dies beispielsweise bei Fernsehbildschirmen der Fall ist. Da jedoch die Laserlichtpulse bei der erfindungsgemäßen Belichtungsvorrichtung von nur niedriger Dauer sind, bleibt der Flächenlichtmodulator den thermischen Anforderungen gewachsen. Durch die schnelle Programmierbarkeit oder Adressierbarkeit des Flächenlichtmodulators kann dieser während der Verfahrbewegung des Positioniertisches zwischen zwei aufeinanderfolgenden Teilbildern einer zu erzeugenden Gesamtstruktur umprogrammiert oder umadressiert werden. Damit ist nicht nur im Falle der Direktbelichtung von Halbleiterscheiben mit wiederholten Strukturen eine kurze Belichtungspulsfolge möglich, sondern ebenfalls aufgrund der schnellen Umprogrammierbarkeit des Flächenlichtmodulators die Erzeugung von unregelmäßigen Strukturen möglich.

Weiterbildungen der erfindungsgemäßen Belichtungsvorrichtung sind in den Unteransprüchen angegeben.

Nachfolgend wird unter Bezugnahme auf die beiliegenden Zeichnungen eine bevorzugte Ausführungsform der erfindungsgemäßen Belichtungsvorrichtung näher erläutert. Es zeigen:
- Fig. 1: eine schematische Darstellung der Gesamtstruktur der erfindungsgemäßen Belichtungsvorrichtung;
- Fig. 2: eine Detaildarstellung eines Mustergenerators, eines optischen Schlierensystemes und eines Positioniertisches der erfindungsgemäßen Belichtungsvorrichtung; und
- Fig. 3: eine Detaildarstellung eines Mustergenerators, einer gegenüber der Ausführungsform von Fig. 2 abgewandelten Ausführungsform des optischen Schlierensystemes und des Positioniertisches der erfindungsgemäßen Belichtungsvorrichtung.

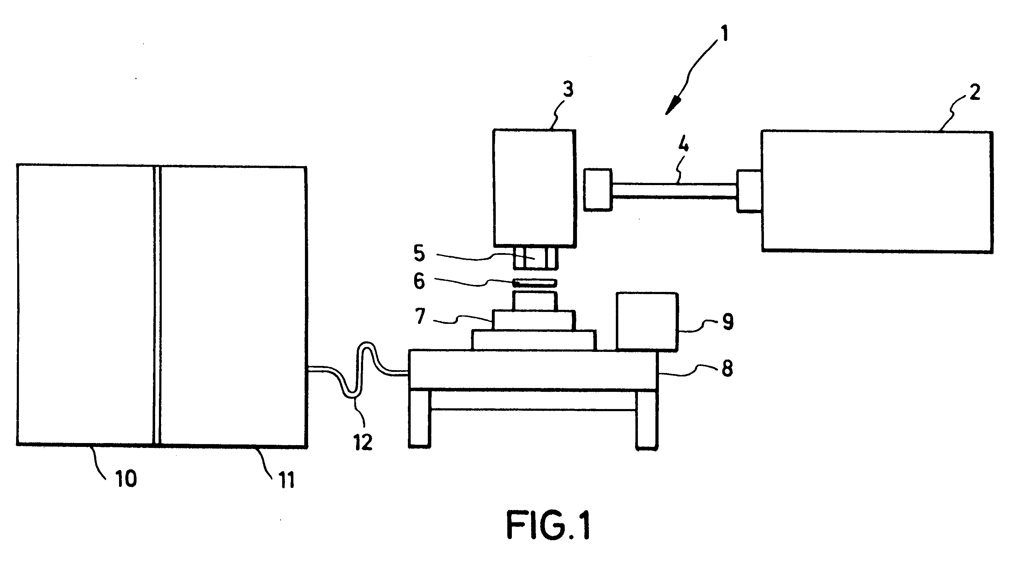

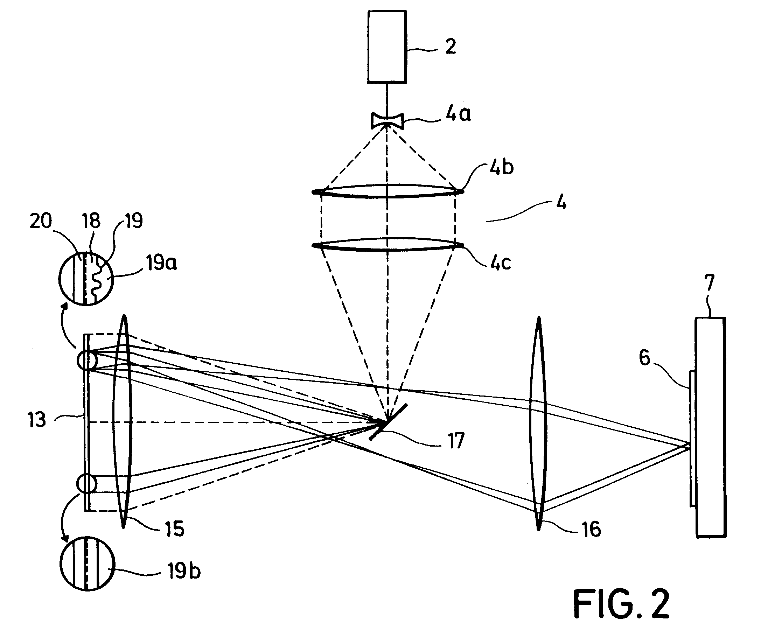

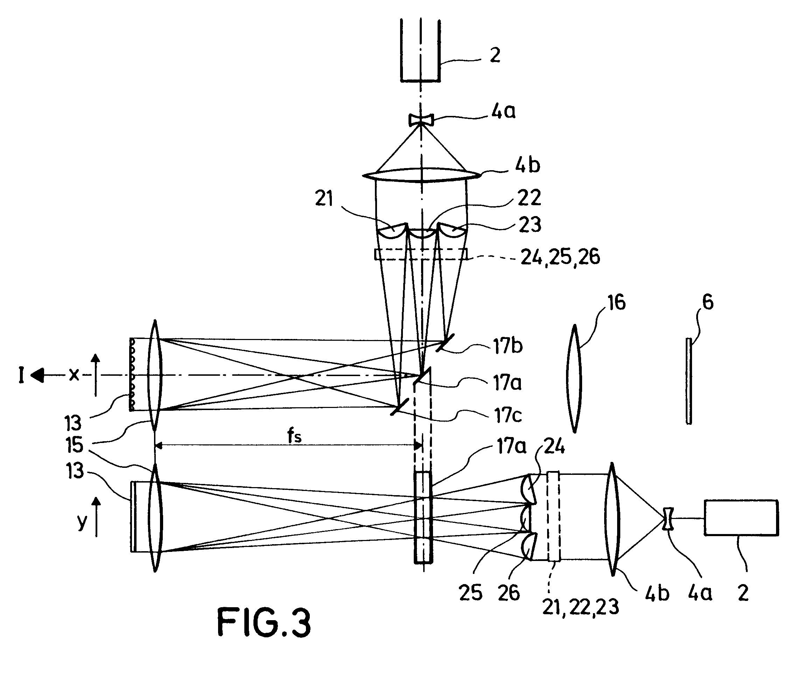

Die in Fig. 1 gezeigte Belichtungsvorrichtung ist in ihrer Gesamtheit mit den Bezugszeichen "1" bezeichnet und dient zum Herstellen von Vorlagen, wie beispielsweise Retikels und Masken für die Fertigung elektronischer Elemente, oder zum Direktbelichten von Substraten oder von Strukturen mit lichtempfindlichen Schichten. Die erfindungsgemäße Belichtungsvorrichtung 1 weist eine Excimer-Laserlichtquelle 2 auf. Diese Excimer-Laserlichtquelle ist eine Gasentladungslaservorrichtung mit Wellenlängen im UV-Bereich von etwa 450 bis 150 nm, die in steuerbarer Weise Lichtpulse mit sehr hoher Lichtintensität pro Puls und hoher Wiederholrate abgibt. Die Excimer-Laserlichtquelle 2 steht mit einem Mustergenerator 3 über eine beleuchtende optische Einheit 4 in Verbindung. Die beleuchtende optische Einheit 4 dient dazu, das Licht von der Excimer-Laserlichtquelle 2 einem später zu erläuternden Flächenlichtmodulator 13 des Mustergenerators 3 in der Weise zuzuführen, daß die Lichtapertur der Excimer-Laserlichtquelle 2 an die Oberfläche des Flächenlichtmodulators angepaßt wird. Bei bevorzugten Ausführungsformen, die nachfolgend unter Bezugnahme auf die Fig. 2 und 3 erläutert werden, ist die beleuchtende optische Einheit 4 durch Linsensysteme von an sich bekannter Struktur gebildet.

Der Mustergenerator bildet mittels einer projizierenden optischen Einheit 5 in noch näher zu beschreibenden Weise ein Muster auf eine Vorlage 6 ab, die von einem x-y-Θ-Positioniertisch gehalten wird.

Die projizierende optische Einheit 5 dient nicht nur zur Abbildung des von dem Mustergenerator 3 erzeugten Musters auf der Vorlage 6, sondern gleichfalls zur gewünschten Vergrösserung oder Verkleinerung bei der Abbildung und, soweit dies gewünscht ist, zur Autofokussierung der Abbildung auf der Vorlage 6.

Wie bereits erläutert, kann es sich bei der Vorlage beispielsweise um Retikels oder Masken handeln. Im Falle der Direktbelichtung, die gleichfalls eingangs erläutert wurde, trägt der x-y-Θ-Positioniertisch 7 anstelle der Vorlage 6 eine zu belichtende Halbleiterscheibe, ein sonstiges, mittels Photolithographie zu erzeugendes Element oder eine Struktur mit einer lichtempfindlichen Schicht, die zu beschriften oder zu belichten ist.

Der Positioniertisch 7 ist auf einer schwingungsisolierenden Trägerkonstruktion 8 angeordnet. Auf dieser Trägerkonstruktion 8 kann eine Be- und Entladestation 9 für weitere Vorlagen 6 bzw. Halbleiterelemente oder zu belichtende Strukturen vorgesehen sein. Die Be- und Entladestation 9 kann in einer in der Halbleiterfertigung üblichen Art zum automatischen Beschicken des Positioniertisches 7 mit den zu belichtenden Vorlagen oder Substraten oder sonstigen Halbleiterelementen ausgestaltet sein.

Ein Steuerrechner 10 mit zugehöriger Steuerelektronik 11 übernimmt alle Steuerfunktionen für die Belichtungsvorrichtung. Insbesondere stehen der Steuerrechner 10 und die Steuerelektronik 11 mit dem Positioniertisch 7 zum Zwecke der rechnergesteuerten Lagesteuerung des Positioniertisches in Verbindung. Der Steuerrechner 10 programmiert bzw. adressiert den Mustergenerator 3 in Abhängigkeit von der jeweiligen Steuerlage des Positioniertisches 7 zum aufeinanderfolgenden Erzeugen von Teilbildern auf der Vorlage 6, aus denen sich die belichtete Gesamtstruktur ergibt. Als Datenträger wird eine Magnetbandeinheit oder eine LAN-Schnittstelle (nicht dargestellt) eingesetzt.

Wie in Fig. 2 dargestellt ist, umfaßt der Mustergenerator 3 einen Flächenlichtmodulator oder zweidimensionalen Lichtmodulator 13 sowie ein optisches Schlierensystem, das ein dem Flächenlichtmodulator 13 zugewandtes Schlierenobjektiv 15, ein dem Flächenlichtmodulator 13 abgewandtes Projektionsobjektiv 16 und eine zwischen dem Schlierenobjektiv 15 und dem Projektionsobjektiv 16 angeordnete Spiegelvorrichtung 17 aufweist.

Das Schlierenobjektiv 15 ist mit einem bezogen auf seine Brennweite geringen Abstand zu dem Flächenlichtmodulator 13 angeordnet.

Die Spiegelvorrichtung 17 liegt in der Brennebene des Schlierenobjektivs sowie in dessen optischer Achse. Zwischen der Excimer-Laserlichtquelle und der Spiegelvorrichtung 17 liegen eine Strahlaufweitungsoptik 4a, 4b und eine Fokussierungsoptik 4c, welche der Fokussierung des von der Excimer-Laserlichtquelle 2 abgegebenen Lichtes auf die Spiegelvorrichtung 17 dienen und welche Bestandteile der beleuchtenden optischen Einheit 4 sind.

Der Flächenlichtmodulator 13 umfaßt eine viskoelastische Steuerschicht 18, die in Richtung zu dem Schlierenobjektiv 15 von einer reflektierenden Oberfläche 19 abgeschlossen ist, welche beispielsweise von einem Metallfilm gebildet sein kann. Ferner umfaßt der Flächenlichtmodulator 13 eine sogenannte aktive Adressierungsmatrix 20, die aus einer monolithisch integrierten Anordnung von MOS-Transistoren mit zugeordneten Steuerelektrodenpaaren gebildet sein kann. Typischerweise umfaßt die Adressierungsmatrix 20 2000 x 2000 Bildelemente. Jedem Bildelement oder Oberflächenbereich 19a, 19b, ... der reflektierenden Oberfläche 19 der Adressierungsmatrix 20 sind zwei Transistoren mit ein oder mehreren Elektrodenpaaren zugeordnet, die jeweils ein Diffraktionsgitter mit einer oder mehreren Gitterperioden mit der viskoelastischen Schicht 18 und ihrer reflektierenden Oberfläche 19 bilden.

Wenn ein Oberflächenbereich 19a, 19b, ... durch Anlegen von entgegengesetzten Spannungen an den beiden Elektroden eines Elektrodenpaares des betreffenden Oberflächenbereiches adressiert wird (logisch "1"), nimmt die reflektierende Oberfläche 19 einen im Querschnitt etwa sinusförmigen Verlauf an. Bei Nicht-Adressierung ist der betreffende Oberflächenbereich 19a, 19b, ... eben. Wenn ein Lichtstrahl auf einen nicht-adressierten Oberflächenbereich 19a, 19b, ... einfällt, wird dieser reflektiert und über einen Spiegel der Spiegelvorrichtung 17 zur Lichtquelle zurückgelenkt. Die in der Brennebene des Schlierenobjektivs 15 angeordnete Spiegelvorrichtung 17 dient also einerseits der Umlenkung des von der Lichtquelle 2 stammenden Lichts zu dem Flächenlichtmodulator 13 hin und andererseits als eine Filtervorrichtung für die Herausfilterung von solchen Lichtanteilen, die von den nicht-adressierten Oberflächenbereichen 19a, 19b, ... ungebeugt reflektiert werden.

Für den Fachmann ist es offenkundig, daß in Abweichung zu dem gezeigten Ausführungsbeispiel eine Trennung der beiden Funktionen Lichteinkopplung und Filterung durch Verwendung von zwei separaten Bauelementen erfolgen kann. In diesem Fall ist die Spiegelvorrichtung 17 gegenüber der Brennebene des Schlierenobjektivs 15 entlang der optischen Achse auf dieses hin versetzt anzuordnen. Dabei ist die Verwendung eines teildurchlässigen Spiegels möglich. Die Beugungsebene verschiebt sich dementsprechend in die entgegengesetzte Richtung, so daß zur Herausfilterung des Lichts der nullten Beugungsordnung zusätzlich eine Blende in den Strahlengang einzufügen ist, welche gegenüber der Brennebene des Schlierenobjektivs 15 in Richtung auf das Projektionsobjektiv 16 hin versetzt anzuordnen ist.

Bei Adressierung des betreffenden Bereiches wird das einfallende Licht gebeugt, sodaß höhere Beugungsordnungen an der als Blende wirkenden Spiegelvorrichtung 17 vorbeigehen und mit Hilfe des Projektionsobjektivs 16 scharf auf die Vorlage 6 abgebildet werden können. Auf diese Weise gelangen nur adressierte Oberflächenbereiche 19a, 19b, .... zur Projektion, so daß das am Ort der Vorlage 6 erzeugte Bild dem programmierten logischen Zustand des Flächenlichtmodulators 13 entspricht.

Bis zu 90 % der auf die reflektierende Oberfläche 19 einfallenden Laserintensität können bei der erfindungsgemäßen Belichtungsvorrichtung zur Bilderzeugung beitragen.

Bei der Ausführungsform gemäß Fig. 2 wird durch Fokussierung des von der Excimer-Laserlichtquelle 2 stammenden Lichtes auf die Spiegelvorrichtung 17 am Ort der Spiegelvorrichtung eine einzige Punktlichtquelle erzeugt, mit der der Flächenlichtmodulator 13 beleuchtet wird.

Bei der nachfolgend unter Bezugnahme auf Fig. 3 zu beschreibenden zweiten Ausführungsform der erfindungsgemäßen Belichtungsvorrichtung wird die einzige, in der Brennebene erzeugte Punktlichtquelle des ersten Ausführungsbeispiels durch eine Mehrzahl von im wesentlichen in der Brennebene angeordneten, im wesentlichen punktsymmetrischen Punktlichtquellen ersetzt, die jeweils die gesamte Fläche des Flächenlichtmolators 13 beleuchten.

Bei der nachfolgenden Beschreibung der zweiten Ausführungsform gemäß Fig. 3 werden mit der Ausführungsform von Fig. 2 übereinstimmende Teile mit gleichen Bezugszeichen bezeichnet, so daß eine nochmalige Beschreibung dieser Systemkomponenten unterbleiben kann.

In Abweichung zu der Ausführungsform gemäß Fig. 2 weist die Ausgestaltung der erfindungsgemäßen Belichtungsvorrichtung nach Fig. 3 nicht nur eine einzige Spiegelvorrichtung 17 auf, sondern eine Balkenspiegelanordnung 17a, 17b, 17c, die bei dem hier gezeigten Ausführungsbeispiel mit drei Balkenspiegeln versehen ist. Es können jedoch auch Balkenspiegelanordnungen mit einer höheren Zahl von Balkenspiegeln verwendet werden.

Der mittlere Balkenspiegel 17a liegt im Brennpunkt des Schlierenobjektives 15. Die beiden weiteren Balkenspiegel 17b, 17c sind derart angeordnet, daß das von der Laserlichtquelle 2 stammende, von einem der Balkenspiegel 17b, 17c zu dem Flächenlichtmodulator umgelenkte Licht bei ungebeugter Reflektion durch die nicht- adressierten Oberflächenbereiche 19a, 19b, ... des Flächenlichtmodulators 13 auf den anderen Balkenspiegel 17c, 17b auftrifft und durch diesen in Richtung zu der Laserlichtquelle 2 zurückgesandt wird. Mit anderen Worten sind die Balkenspiegel jeweils paarweise so angeordnet, daß die auf einem Balkenspiegel durch die später zu beschreibende Fokussierung erzeugten Punktlichtquellen den Flächenlichtmodulator 13 derart ganzflächig beleuchten, daß bei ungebeugter Reflektion des Lichtes dieser Punktlichtquellen das reflektierte Licht auf den jeweils anderen Balkenspiegel auftrifft, der somit als Filter für den einen Balkenspiegel dient.

Die obere Darstellung der Fig. 3 zeigt die Belichtungsvorrichtung in der x-z-Ebene, während die untere Darstellung die Belichtungsvorrichtung in der y-z-Ebene längs der Schnittlinie II der oberen Darstellung zeigt.

Die jeweiligen Achsenrichtungen der Balkenspiegel 17a, 17b, 17c liegen in der y-Richtung und somit parallel zu der durch die Welligkeit der Oberfläche 19 des Flächenlichtmodulators 13 erzeugten Phasenstruktur.

Um Punktlichtquellen am Ort der Balkenspiegel 17a, 17b, 17c zu erzeugen, umfaßt die beleuchtende optische Einheit 4 neben der Strahlaufweitungsoptik 4a, 4b für jeden Balkenspiegel jeweils ein Zylinderlinsensystem 21, 22, 23, das parallel zu der Phasenstruktur und somit in der y-Richtung ausgerichtet ist. Diese Zylinderlinsensysteme haben, wie aus der Fig. 3 ersichtlich ist, unterschiedliche Brennweiten zur Fokussierung auf die unterschiedlich beabstandeten Balkenspiegel 17a, 17b, 17c. Ferner umfassen die außerhalb der optischen Achse angeordneten Zylinderlinsensysteme 21, 23 Prismen, um das Licht jeweils in einem solchen Winkel auf die Balkenspiegel 17b, 17c einfallen zu lassen, daß der Flächenlichtmodulator 13 jeweils ganzflächig ausgeleuchtet wird. In dem optischen Weg hinter dem parallel zu der Phasenstruktur liegenden Zylinderlinsensystem 21, 22, 23 ist ein senkrecht zu der Phasenstruktur angeordnetes Zylinderlinsensystem 24, 25, 26 vorgesehen, dessen Aufbau und Anordnung dem soeben beschriebenen Zylinderlinsensystem entspricht. Die hintereinander geschalteten Zylinderlinsensysteme erzeugen bei dem gezeigten Ausführungsbeispiel neun Punktlichtquellen auf den drei Balkenspiegeln 17a, 17b, 17c.

Während des Betriebes wird der Positioniertisch 7 kontinuierlich in einer vorbestimmten Bewegungsrichtung bewegt, während einander sich überlappende Teilbilder der gesamten abzubildenden Struktur auf die Vorlage 6 durch Pulsen der Excimer-Laserlichtquelle 2 abgebildet werden. In der Regel umfaßt die Adressierungsmatrix 20 eine Mehrzahl von funktionsunfähigen Bildelementen aufgrund von Herstellungsfehlern, so daß betreffende Bildelemente nicht oder nicht vollständig in den logischen Zustand "1" bzw. "0" geschaltet werden können. Diese Fehler der Matrix 20 werden dadurch kompensiert, daß alle defekten Bildelemente ermittelt und durch Ansteuerung mit einer logischen "0" stillgelegt werden. Dadurch, daß jede Struktur auf der Vorlage 6 durch einander überlappende Teilbilder erzeugt wird, ist sichergestellt, daß jeder Teil der zu belichtenden Struktur wenigstens einmal durch ein funktionsfähiges Bildelement oder durch einen funktionsfähigen Oberflächenbereich belichtet wird.

Das Erzeugen der gesamten belichteten Struktur während des kontinuierlichen Verfahrens des Positioniertisches 7 führt nicht zu Unschärfen, da die Pulsdauer der gepulsten Excimer-Laserlichtquelle 2 kürzer ist als die minimale Abmessung der zu erzeugenden Struktur geteilt durch die Verfahrgeschwindigkeit des Positioniertisches 7.

Die Datenstruktur für die Ansteuerung der Adressierungsmatrix 20 entspricht im wesentlichen der Datenstruktur für die Ansteuerung von rasterorientierten Laserstrahl- oder Elektronenstrahlgeräten nach dem Stand der Technik. Ein erheblicher Vorteil bei der Verwendung der erfindungsgemäßen Belichtungsvorrichtung besteht darin, daß die für die Übertragung großer Datenmengen notwendige Zeit durch die Unterteilung der Adressierungsmatrix 20 und durch paralleles Programmieren von Teilmatritzen von beispielsweise 16 oder 32 Streifen fast beliebig reduziert werden kann. Ein weiterer Vorteil der erfindungsgemäßen Belichtungsvorrichtung 1 mit der Adressierungsmatrix 20 liegt darin, daß zum Zwecke der Belichtung von sich wiederholenden Strukturen, wie beispielsweise von regelmäßigen Anordnungen integrierter Schaltkreise auf einer Siliziumscheibe, die Adressierungsmatrix 20 für alle identischen Strukturen nur einmal programmiert und das programmierte Bild nur einmal gespeichert werden muß.

Es ist möglich, die erfindungsgemäße Belichtungsvorrichtung 1 mit einem Autokalibrationssystem und mit einem System für die Feinjustierung der Vorlagen 6 beim Direktschreiben zu versehen. Zu diesem Zweck werden Referenzmarken auf dem Positioniertisch 7 und auf der Vorlage 6 vorgesehen und die Adressierungsmatrix 20 als programmierbare Referenzmarke benutzt. Durch eine Autokalibration können Vergrößerungsfehler der projizierenden optischen Einheit 5 und sämtliche Positionierungsfehler kompensiert werden.

## Patentansprüche

1. Belichtungsvorrichtung zum Herstellen von Vorlagen für die Fertigung elektronischer Elemente oder zum Direktbelichten von Scheiben oder Substraten bei den für ihre Herstellung notwendigen fotolithographischen Schritten oder von Strukturen mit lichtempfindlichen Schichten, mit einer Lichtquelle (2) und einem Mustergenerator (3),
dadurch gekennzeichnet,
- daß der Mustergenerator (3) ein optisches Schlierensystem (14) und einen aktiven, Matrix-adressierbaren Flächenlichtmodulator (13) aufweist,
- daß der Flächenlichtmodulator (13) eine reflektierende Oberfläche (19) aufweist, deren adressierte Oberflächenbereiche (19a, 19b, ...) einfallendes Licht gebeugt reflektieren und deren nicht adressierte Oberflächenbereiche (19a, 19b, ...) einfallendes Licht ungebeugt reflektieren,
- daß das Schlierensystem (14) ein Flächenlichtmodulatorseitiges Schlierenobjektiv (15), ein dem Flächenlichtmodulator (13) abgewandtes Projektionsobjektiv (16) und eine zwischen diesen Objektiven (15, 16) angeordnete Spiegelvorrichtung (17) aufweist, die Licht von der Lichtquelle (2) auf die Oberfläche (19) des Flächenlichtmodulators (13) richtet,
- daß eine Fokussiereinrichtung (4) zum Fokussieren des Lichts von der Lichtquelle (2) auf die Spiegelvorrichtung (17) vorgesehen ist,
- daß das Schlierenobjektiv (15) mit einem bezogen auf seine Brennweite geringen Abstand zu dem Flächenlichtmodulator (13) angeordnet ist,
- daß eine Filtervorrichtung (17) zwischen dem Schlierenobjektiv (15) und dem Projektionsobjektiv (16) angeordnet ist, die derart ausgebildet ist, daß sie das von den nicht-adressierten Oberflächenbereichen (19a, 19b, ...) des Flächenlichtmodulators (13) reflektierte, ungebeugte Licht herausfiltert und das von den adressierten Oberflächenbereichen (19a, 19b, ...) reflektierte, gebeugte Licht über das Projektionsobjektiv (16) zu der Vorlage (6), der Scheibe, dem Substrat oder der Struktur durchläßt,
- daß ein verfahrbarer Positioniertisch (7) vorgesehen ist, auf dem die Vorlage (6) oder das elektronische Element oder die Struktur derart festlegbar ist, daß die adressierten Oberflächenbereiche (19a, 19b, ...) des Flächenlichtmodulators (13) auf der Vorlage (6), der Scheibe, dem Substrat oder der Struktur scharf abbildbar sind,
- daß die Lichtquelle eine gepulste Laserlichtquelle (2) ist,
- daß die Laserlichtquelle derart ausgebildet ist, daß deren Pulsdauer (2) kürzer als die minimale Strukturabmessung der zu erzeugenden Vorlage, der Scheibe, des Substrats oder der Struktur geteilt durch die Verfahrgeschwindigkeit des Positioniertisches (7) ist, und
- daß die Vorlage (6), die Scheibe, das Substrat oder die Struktur während des Verfahrens des Positioniertisches aus einer Mehrzahl von aufeinanderfolgenden Teilbildern durch entsprechende Adressierung des Flächenlichtmodulators (13) zusammengesetzt wird.

2. Belichtungsvorrichtung nach Anspruch 1, dadurch gekennzeichnet,
- daß die Spiegelvorrichtung (17) um die Brennweite des Schlierenobjektivs (15) von diesem beabstandet ist, und
- daß die Spiegelvorrichtung (17) die Filtervorrichtung bildet, indem sie das von den nicht-adressierten Oberflächenbereichen (19a, 19b, ...) reflektierte, ungebeugte Licht zu der Lichtquelle (2) zurücklenkt.

3. Belichtungsvorrichtung nach Anspruch 1, dadurch gekennzeichnet,
- daß die Spiegelvorrichtung (17) von dem Schlierenobjektiv (15) um weniger als dessen Brennweite beabstandet ist, und
- daß die Filtervorrichtung als eine Blende für von den nicht-adressierten Oberflächenbereichen (19a, 19b, ...) reflektiertes, ungebeugtes Licht ausgebildet ist, welche von dem Schlierenobjektiv (15) um mehr als dessen Brennweite beabstandet ist.

4. Belichtungsvorrichtung nach einem der Ansprüche 1 bis 3, dadurch gekennzeichnet,
daß die Spiegelvorrichtung einen Balkenspiegel (17) umfaßt, dessen Längsachse (y) parallel zu der durch die Welligkeit der Oberfläche (19) des Flächenlichtmodulators (13) erzeugten Phasenstruktur angeordnet ist.

5. Belichtungsvorrichtung nach Anspruch 4, dadurch gekennzeichnet,
- daß die Spiegelvorrichtung eine Mehrzahl von Balkenspiegeln (17a, 17b, 17c) umfaßt, von denen einer im Brennpunkt des Schlierenobjektivs (15) angeordnet ist, und
- daß je zwei weitere Balkenspiegel (17b, 17c) derart angeordnet sind, daß das von der Lichtquelle (2) stammende, von einem der Balkenspiegel (17b, 17c) zu dem Flächenlichtmodulator (13) umgelenkte Licht bei ungebeugter Reflektion durch die nicht-adressierten Oberflächenbereiche (19a, 19b, ...) des Flächenlichtmodulators (13) auf den anderen Balkenspiegel (17c, 17b) auftrifft.

6. Belichtungsvorrichtung nach Anspruch 5, gekennzeichnet durch
- eine Strahlaufweitungsoptik (4a, 4b), die das von der Lichtquelle (2) stammende Licht zu einem breiten, im wesentlichen parallelen Lichtbündel umformt,
- ein in Richtung der Phasenstruktur ausgerichtetes Zylinderlinsensystem mit einer Anzahl von Zylinderlinsen (21, 22, 23), welche der Anzahl von Balkenspiegeln (17a, 17b, 17c) entspricht, und
- ein hierzu senkrecht angeordnetes zweites Zylinderlinsensystem (24, 25, 26).

7. Belichtungsvorrichtung nach einem der Ansprüche 1 bis 6, dadurch gekennzeichnet,
daß die gepulste Laserlichtquelle eine Excimer-Laserlichtquelle (2) ist.

8. Belichtungsvorrichtung nach einem der Ansprüche 1 bis 7, dadurch gekennzeichnet,
daß der Flächenlichtmodulator (13) und der Positioniertisch (7) im Betrieb derart angesteuert werden, daß jedes Bildelement der zu belichtenden Vorlage oder des Elementes oder der Struktur wenigstens zweifach bei einander teilweise überlappenden Abbildungen in der Weise belichtet wird, daß der Versatz des abgebildeten Bildelementes mit dem Verfahrweg des Positioniertisches zwischen den Pulsen zum Erzeugen der Abbildungen übereinstimmt.

9. Belichtungsvorrichtung nach einem der Ansprüche 1 bis 8, dadurch gekennzeichnet,
daß bei der Matrix-Adressierung des Flächenlichtmodulators (13) als funktionsunfähig erkannte Oberflächenbereiche (19a, 19b, ...) nicht adressiert werden.

10. Belichtungsvorrichtung nach einem der Ansprüche 1 bis 9, dadurch gekennzeichnet,
daß jedem Oberflächenbereich (19a, 19b, ...) des Flächenlichtmodulators (13) zwei Transistoren mit jeweils einem Steuerelektrodenpaar oder mehreren Steuerelektrodenpaaren zugeordnet sind, die bei Adressierung des betreffenden Oberflächenbereiches (19a, 19b, ...) je ein oder mehrere Diffraktionsgitter mit der reflektierenden Oberfläche (19) und der von ihr überdecketen viskoelastischen Steuerschicht (18) erzeugen.

11. Belichtungsvorrichtung nach einem der Ansprüche 1 bis 10, gekennzeichnet durch
eine automatische Belade- und Entladevorrichtung für Scheiben oder Substrate, die eine vollautomatische Belichtung eines Loses von Scheiben oder Substraten gestattet.

12. Belichtungsvorrichtung nach einem der Ansprüche 1 bis 11, gekennzeichnet durch
eine Vorjustiereinrichtung und eine Feinjustiereinrichtung, die das paßgenaue wiederholte Belichten der Substrate während des Fertigungsprozesses gestattet.

13. Belichtungsvorrichtung nach Anspruch 12, dadurch gekennzeichnet,
daß der Flächenlichtmodulator (13) als programmierbare Referenzmarke bei der Vor- und Feinjustierung benutzt wird.

14. Belichtungsvorrichtung nach einem der Ansprüche 1 bis 13, dadurch gekennzeichnet,
daß der Flächenlichtmodulator (13) eine viskoelastische Steuerschicht (18) aufweist, auf der die reflektierende Oberfläche (19) angeordnet ist.

15. Belichtungsvorrichtung nach Anspruch 14, dadurch gekennzeichnet,
- daß die reflektierende Oberfläche des Flächenlichtmodulators (13) mit einer Flüssigkristallschicht bedeckt ist, und
- daß die elektrisch adressierbaren Oberflächenbereiche (19a, 19b, ...) eine Phasenverschiebung und damit eine Beugung des einfallenden Lichtes bewirken.

16. Belichtungsvorrichtung nach einem der Ansprüche 1 bis 15, dadurch gekennzeichnet,
daß der Flächenlichtmodulator (13) eine aus adressierbaren mechanischen Zungen bestehende reflektierende Oberfläche aufweist, deren Verbiegung eine Phasenverschiebung und damit eine Beugung des Lichtes bewirkt.

## Claims

1. Illumination device for producing models used for manufacturing electronic elements, or for direct illumination of wafers or substrates during the photolithographic steps required for their production, or for direct illumination of structures including light-sensitive layers, comprising a light source (2) and a pattern generator (3),
characterized in
- that the pattern generator (3) includes an optical schlieren system (14) and an active, matrix-addressable surface light modulator (13),
- that the surface light modulator (13) has a reflective surface (19) whose addressed surface areas (19a, 19b, ..) diffractively reflect incident light and whose non-addressed surface areas (19a, 19b, ...) undiffractively reflect incident light,
- that the schlieren system (14) comprises a schlieren lens (15) arranged on the side of the surface light modulator (13), a projection lens (16) facing away from the surface light modulator (13), and a mirror device (17) which is arranged between these lenses (15, 16) and which directs light coming from the light source (2) onto the surface (19) of the surface light modulator (13),
- that a focussing means (4) is provided, which is used for focussing the light coming from the light source (2) onto the mirror device (17),
- that the schlieren lens (15) is arranged at a distance from the surface light modulator (13) which is short relative to the focal length of said lens,
- that a filter device (17) is arranged between the schlieren lens (15) and the projection lens (16), said filter device being provided with a structural design of such a nature that it will filter out the undiffracted light reflected by the non-addressed surface areas (19a, 19b, ...) of the surface light modulator (13) and that it will permit the diffracted light, which is reflected by the addressed surface areas (19a, 19b, ...), to pass via the projection lens (16) to the model (6), to the wafer, to the substrate or to the structure,
- that a displaceable positioning table (7) is provided on which the model (6), or the electronic element, or the structure can be secured in position in such a way that a sharp image of the addressed surface areas (19a, 19b, ...) of the surface light modulator (13) can be formed on the model (6), on the wafer, on the substrate, or on the structure,
- that the light source is a pulsed laser light source (2),
- that the pulsed laser light source (2) is provided with a structural design of such a nature that the pulse duration thereof is shorter than the minimum structural dimension of the model to be produced, of the wafer, of the substrate, or of the structure divided by the displacement rate of the positioning table (7), and
- that, during the displacement of the positioning table, the model (6), the wafer, the substrate, or the structure is put together using a plurality of successive partial images by adequate addressing of the surface light modulator (13).

2. Illumination device according to claim 1, characterized in
- that the mirror device (17) is arranged at a distance from the schlieren lens (15) which corresponds to the focal length of said lens (15), and
- that the mirror device (17) constitutes the filter device insofar as it returns the undiffracted light, which is reflected by the non-addressed surface areas (19a, 19b, ...), to the light source (2)

3. Illumination device according to claim 1, characterized in
- that the mirror device (17) is arranged at a distance from the schlieren lens (15) which is shorter than the focal length of said lens (15), and
- that the filter device is constructed as a shutter for undiffracted light reflected by the non-addressed surface areas (19a, 19b, ...), said shutter being arranged at a distance from the schlieren lens (15) which exceeds the focal length of said lens (15).

4. Illumination device according to one of the claims 1 to 3, characterized in
that the mirror device includes a bar-type mirror (17) whose longitudinal axis (y) extends parallel to the phase structure produced by the waviness of the surface (19) of the surface light modulator (13).

5. Illumination device according to claim 4, characterized in
- that the mirror device includes a plurality of bar-type mirrors (17a, 17b, 17c), one of said bar-type mirrors being arranged at the focus of the schlieren lens (15), and
- that two additional bar-type mirrors (17b, 17c) are arranged such that the light coming from the light source (2) and deflected by one of the bar-type mirrors (17b, 17c) towards the surface light modulator (13) will fall on the other bar-type mirror (17c, 17b) in the case of undiffracted reflection by the non-addressed surface areas (19a, 19b, ...) of the surface light modulator (13).

6. Illumination device according to claim 5, characterized by
- a beam expansion optical system (4a, 4b) which transforms the light coming from the light source (2) into a broad, essentially parallel bundle of light,
- a cylindrical lens system, which is orientated in the direction of the phase structure and which includes a number of cylindrical lenses (21, 22, 23) corresponding to the number of bar-type mirrors (17a, 17b, 17c), and
- a second cylindrical lens system (24, 25, 26) arranged perpendicularly to said first-mentioned cylindrical lens system.

7. Illumination device according to one of the claims 1 to 6, characterized in
that the pulsed laser light source is an excimer laser light source (2).

8. Illumination device according to one of the claims 1 to 7, characterized in
that during operation the surface light modulator (13) and the positioning table (7) are controlled such that each pixel of the model, or of the element, or of the structure to be illuminated is illuminated at least twice with partially overlapping images in such a way that the displacement of the imaged pixel will correspond to the distance by which the positioning table has been displaced between the pulses for producing the images.

9. Illumination device according to one of the claims 1 to 8, characterized in
that, upon carrying out matrix addressing of the surface light modulator (13), surface areas (19a, 19b, ...) which have been recognized as being incapable of functioning are not addressed.

10. Illumination device according to one of the claims 1 to 9, characterized in
that each surface area (19a, 19b, ...) of the surface light modulator (13) has associated therewith two transistors each provided with one pair of control electrodes or with several pairs of control electrodes, which, in response to addressing of the respective surface area (19a, 19b, ...), will each produce one or several diffraction grating(s) with the reflective surface (19) and the viscoelastic control layer (18) covered by said surface (19).

11. Illumination device according to one of the claims 1 to 10, characterized by
an automatic loading and unloading device for wafers or substrates, which permits fully automatic illumination of a batch of wafers or substrates.

12. Illumination device according to one of the claims 1 to 11, characterized by
a preadjustment means and a fine adjustment means permitting accurate, repeated illuminations of the substrates during the production process.

13. Illumination device according to claim 12, characterized in
that the surface light modulator (13) is used as a programmable reference mark during preadjustment and fine adjustment.

14. Illumination device according to one of the claims 1 to 13, characterized in
that the surface light modulator (13) is provided with a viscoelastic control layer (18) having arranged thereon the reflective surface (19).

15. Illumination device according to claim 14, characterized in
- that the reflective surface of the surface light modulator (13) is covered with a liquid-crystal layer, and
- that the electrically addressable surface areas (19a, 19b, ...) cause a phase displacement and, consequently, a diffraction of the incident light.

16. Illumination device according to one of the claims 1 to 15, characterized in
that the surface light modulator (13) is provided with a reflective surface consisting of addressable mechanical reeds, and that bending of said reeds will cause a phase displacement and, consequently, a diffraction of the light.

## Revendications

1. Dispositif d'exposition lumineuse destiné à la réalisation de modèles pour la fabrication d'éléments électroniques, ou à l'exposition directe de plaques et substrats lors des étapes photolithographiques nécessaires à leur réalisation, ou de structures à couches photosensibles, avec une source de lumière (2) et un générateur de motifs (3), caractérisé en ce
- que le générateur de motifs (3) présente un système optique strioscopique (14) et un modulateur de lumière de surface (13) à adressage matriciel actif,
- que le modulateur de lumière de surface (13) présente une surface réfléchissante (19) dont les zones de surface adressées (19a, 19b, ...) réfléchissent diffractée la lumière incidente et dont les zones de surface non-adressées (19a, 19b, ...) réfléchissent non-diffractée la lumière incidente,
- que le système strioscopique (14) présente un objectif strioscopique (15) du côté du modulateur de lumière de surface, un objectif de projection (16) du côté opposé au modulateur de lumière de surface (13) et un dispositif de miroir (17), disposé entre ces objectifs (15, 16), qui dirige la lumière de la source de lumière (2) vers la surface (19) du modulateur de lumière de surface (13),
- qu'il est prévu un dispositif de focalisation (4) destiné à concentrer la lumière de la source de lumière (2) sur le dispositif de miroir (17),
- que l'objectif strioscopique (15) est disposé à une faible distance du modulateur de lumière de surface (13), par rapport à sa distance focale,
- qu'entre l'objectif strioscopique (15) et l'objectif de projection (16) est disposé un dispositif de filtration (17) qui se présente de telle manière qu'il filtre la lumière non-diffractée réfléchie par les zones de surface (19a, 19b, ...) non-adressées du modulateur de lumière de surface (13) et qu'il laisse passer la lumière diffractée réfléchie par les zones de surface (19a, 19b, ...) adressées, par l'objectif de projection (16), vers le modèle (6), la plaque, le substrat ou la structure,
- qu'il est prévu un plateau de positionnement (7) mobile, sur lequel peut être fixé le modèle (6) ou l'élément électronique ou la structure de telle manière que les zones de surface (19a, 19b, ...) adressées du modulateur de lumière de surface (13) peuvent être reproduites nettement sur le modèle (6), la plaque, le substrat ou la structure,
- que la source de lumière est une source de lumière laser pulsée (2),
- que la source de lumière laser (2) se présente de telle manière que sa durée d'impulsion est plus courte que la dimension de structure minimale du modèle (6), de la plaque, du substrat ou de la structure à produire divisée par la vitesse de déplacement du plateau de positionnement (7), et
- que le modèle (6), la plaque, le substrat ou la structure est composé(e), pendant le déplacement du plateau de positionnement, d'une pluralité d'images partielles successives, par l'adressage correspondant du modulateur de lumière de surface (13).

2. Dispositif d'exposition lumineuse suivant la revendication 1, caractérisé en ce
- que le dispositif de miroir (17) est distant de l'objectif strioscopique (15) de la distance focale de ce dernier, et
- que le dispositif de miroir (17) constitue le dispositif de filtration en ce qu'il renvoie à la source de lumière (2) la lumière non-diffractée réfléchie par les zones de surface (19a, 19b, ...) non-adressées.

3. Dispositif d'exposition lumineuse suivant la revendication 1, caractérisé en ce
- que le dispositif de miroir (17) est distant de l'objectif strioscopique (15) de moins de la distance focale de ce dernier, et
- que le dispositif de filtration se présente sous forme de diaphragme pour la lumière non-diffractée réfléchie par les zones de surface (19a, 19b, ...) non-adressées, qui est distant de l'objectif strioscopique (15) de plus de la distance focale de ce dernier.

4. Dispositif d'exposition lumineuse suivant l'une des revendications 1 à 3, caractérisé en ce que le dispositif de miroir comporte un miroir en barre (17) dont l'axe longitudinal (y) est disposé parallèle à la structure en phase générée par l'ondulation de la surface (19) du modulateur de lumière de surface (13).

5. Dispositif d'exposition lumineuse suivant la revendication 4, caractérisé en ce
- que le dispositif de miroir présente une pluralité de miroirs en barre (17a, 17b, 17c) dont l'un est disposé au point focal de l'objectif strioscopique (15), et
- que chaque fois deux autres miroirs en barre (17b, 17c) sont disposés de telle manière que la lumière provenant de la source de lumière (2) et déviée vers le modulateur de lumière de surface (13) par l'un des miroirs en barre (17b, 17c) arrive, à réflexion non-diffractée par les zones de surface (19a, 19b, ...) non-adressées du modulateur de lumière de surface (13), sur l'autre miroir en barre (17c, 17b).

6. Dispositif d'exposition lumineuse suivant la revendication 5, caractérisé par
- une optique d'élargissement de rayon (4a, 4b) qui transforme la lumière provenant de la source de lumière (2) en un faisceau lumineux large sensiblement parallèle,
- un système de lentilles cylindriques, orienté en direction de la structure en phase, avec un nombre de lentilles cylindriques (21, 22, 33) qui correspond au nombre de miroirs en barre (17a, 17b, 17c), et
- un second système de lentilles cylindriques (24, 25, 26) disposé perpendiculairement à ce dernier.

7. Dispositif d'exposition lumineuse suivant l'une des revendications 1 à 6, caractérisé en ce que la source de lumière laser pulsée est une source de lumière laser à excimer (2).

8. Dispositif d'exposition lumineuse suivant l'une des revendications 1 à 7, caractérisé en ce que le modulateur de lumière de surface (13) et le plateau de positionnement (7) sont commandés, en fonctionnement, de telle manière que chaque élément d'image du modèle ou de l'élément ou de la structure à exposer est exposé au moins deux fois dans des reproductions se recouvrant partiellement de telle manière que le décalage de l'élément d'image reproduit correspond au trajet de déplacement du plateau de positionnement entre les impulsions pour la génération des reproductions.

9. Dispositif d'exposition lumineuse suivant l'une des revendications 1 à 8, caractérisé en ce que lors de l'adressage matriciel du modulateur de lumière de surface (13) les zones de surface (19a, 19b, ...) reconnues fonctionnelles ne sont pas adressées.

10. Dispositif d'exposition lumineuse suivant l'une des revendications 1 à 9, caractérisé en ce qu'à chaque zone de surfaces (19a, 19b, ...) du modulateur de lumière de surface (13) sont associés deux transistors avec, chacun, une paire d'électrodes de commande ou plusieurs paires d'électrodes de commande qui, lors de l'adressage de la zone de surface (19a, 19b, ...) concernée, génèrent, chacune, un ou plusieurs réseaux de diffraction avec la surface réfléchissante (19) et la couche d'excitation visco-élastique (18) qu'elle recouvre.

11. Dispositif d'exposition lumineuse suivant l'une des revendications 1 à 10, caractérisé par un dispositif de chargement et déchargement automatique pour plaques ou substrats qui permet une exposition lumineuse entièrement automatique d'un lot de plaques ou substrats.

12. Dispositif d'exposition lumineuse suivant l'une des revendications 1 à 11, caractérisé par un dispositif de préréglage et un dispositif de réglage fin qui permettent l'exposition lumineuse répétée avec précision des substrats au cours du processus de fabrication.

13. Dispositif d'exposition lumineuse suivant la revendication 12, caractérisé en ce que le modulateur de lumière de surface (13) est utilisé comme repère programmable lors du préréglage et du réglage fin.

14. Dispositif d'exposition lumineuse suivant l'une des revendications 1 à 13, caractérisé en ce que le modulateur de lumière de surface (13) présente une couche d'excitation visco-élastique (18) sur laquelle est disposée la surface réfléchissante (19).

15. Dispositif d'exposition lumineuse suivant la revendication 14, caractérisé en ce
- que la surface réfléchissante du modulateur de lumière de surface (13) est recouverte d'une couche de cristal liquide, et
- que les zones de surface (19a, 19b, ...) adressables électriquement provoquent un déphasage et, de ce fait, une diffraction de la lumière incidente.

16. Dispositif d'exposition lumineuse suivant l'une des revendications 1 à 15, caractérisé en ce que le modulateur de lumière de surface (13) présente une surface réfléchissante composée de languettes mécaniques adressables dont la déformation provoque un déphasage et, de ce fait, une diffraction de la lumière incidente.
